# EUROPEAN PATENT APPLICATION

(11) **EP 4 549 218 A1**
(43) Date of publication of application: **07.05.2025**
(21) Application number: 24209393.8
(22) Date of filing: 29.10.2024
(51) Int. Cl.: B60K 35/10, B60K 35/53, B60K 35/55, B60R 11/02, B60R 11/00

(54) **DISPLAY DEVICE**

(30) Priority: 01.11.2023 JP 2023187530
(71) Applicant: Alps Alpine Co., Ltd., Ota-ku, Tokyo 145-8501 (JP)
(72) Inventor: Shirashima, Hitoshi, Iwaki-city, Fukushima (JP)
(74) Representative: Schmitt-Nilson Schraud Waibel Wohlfrom Patentanwälte Partnerschaft mbB

(57) **Abstract**

A display device includes a display unit movably attached to an inside of a panel; a first opening and a second opening formed in the panel with a distance between the first opening and the second opening; and a moving mechanism provided inside the panel, the moving mechanism being configured to move the display unit using power, wherein the display unit moved by the moving mechanism is stopped at a position where a part of a display screen protrudes from each of the first opening and the second opening.

## Description

The present disclosure relates to a display device which includes a first opening and a second opening for exposing a display screen of a display unit on a panel, and which is installed in, for example, an automobile.

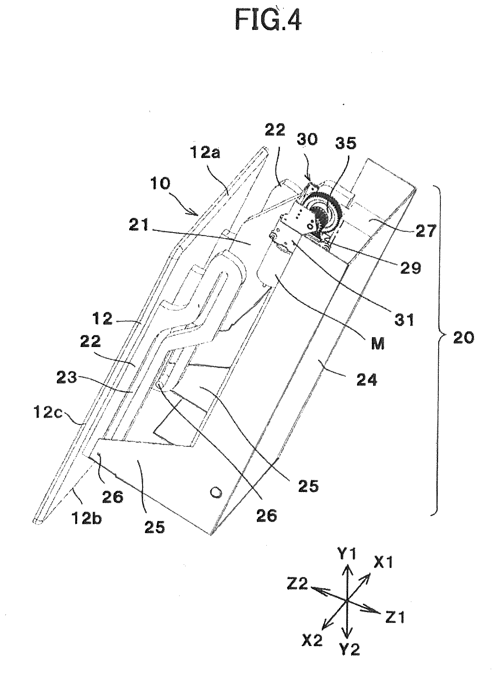

An in-vehicle display device described in JP 2005-274192 A is provided with a storage space in an instrument panel, and a liquid crystal monitor can be stored in the storage space. The liquid crystal monitor is continuously moved by the driving unit from a state where the liquid crystal monitor is completely exposed upward from the storage space to a state where the liquid crystal monitor is completely stored in the storage space. When it is necessary to secure the driving field of view, the liquid crystal monitor is stored as illustrated in FIG. 4A. When one line of character information is displayed while the vehicle is traveling, the liquid crystal monitor is moved upward and slightly exposed as illustrated in FIG. 4B. When reproducing a DVD or receiving a high-definition broadcast, the liquid crystal monitor is raised as illustrated in FIG. 4C so that a video image with an aspect ratio of 16:9 can be displayed. When a standard image quality broadcast is received, the liquid crystal monitor is brought into a completely protruded state as illustrated in FIG. 4D.

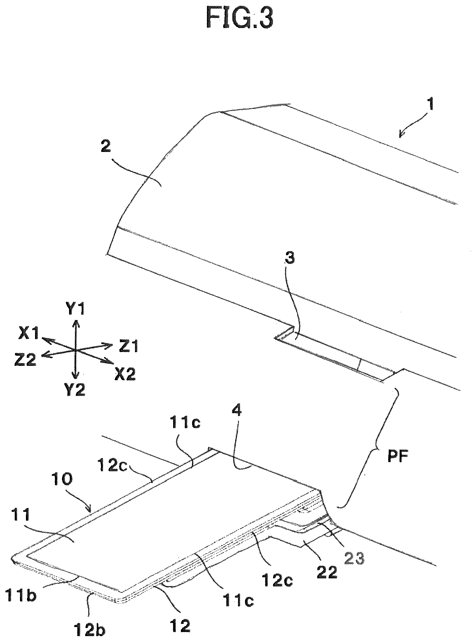

In the display device described in JP 2008-230356 A, a display is provided in a center console, and the display is movable between a "hiding position" at which a part of the display protrudes as illustrated in FIG. 3B and an "exposing position" in which the display protrudes greatly as illustrated in FIG. 3A. When the display is in the "exposed position" of FIG. 3A, the navigation image is displayed, and when the display is in the "hidden position" of FIG. 3B, the "Turn by Turn" image is displayed.

The present disclosure relates to a display device according to the appended claims. Embodiments are disclosed in the dependent claims.

According to an embodiment of the present disclosure, a display device is provided. The display device includes
a display unit movably attached to an inside of a panel;
a first opening and a second opening formed in the panel with a distance between the first opening and the second opening; and
a moving mechanism provided inside the panel, the moving mechanism being configured to move the display unit using power,
wherein the display unit moved by the moving mechanism is stopped at a position where a part of a display screen protrudes from each of the first opening and the second opening.

In the display device, it is preferable that the display unit is moved by the moving mechanism to change a dimension of a protrusion of the display screen from the first opening and a dimension of a protrusion of the display screen from the second opening.

According to another embodiment of the present disclosure, a display device is provided. The display device includes
a display unit movably attached to an inside of a panel;
a first opening and a second opening formed in the panel with a distance between the first opening and the second opening; and
a moving mechanism provided inside the panel, the moving mechanism being configured to move the display unit using power,
wherein the display unit moved by the moving mechanism is stopped at a position where at least a part of the display screen protrudes from the first opening and at a position where at least a part of the display screen protrudes from the second opening.

In the display device according to another embodiment of the present disclosure, the display unit moved by the moving mechanism may be stopped at a position where a part of the display screen protrudes only from the first opening. In this case, it is preferable that the display unit is moved by the moving mechanism to change a dimension of a protrusion of the display screen from the first opening.

In the display device according to another embodiment of the present disclosure, the display unit moved by the moving mechanism may be stopped at a position where a part of the display screen protrudes from only the second opening. In this case, it is preferable that the display unit is moved by the moving mechanism to change the dimension of a protrusion of the display screen from the second opening.

In the display device according to an embodiment of the present disclosure, the panel is a part of a dashboard, an instrument panel, or a console provided in a vehicle interior, the first opening opens upward, and the second opening opens downward.

In the display device according to an embodiment of the present disclosure, an operation portion may be provided on a surface of the dashboard, the instrument panel, or the console between the first opening and the second opening, and/or a display portion may be provided on a surface of the dashboard, the instrument panel, or the console between the first opening and the second opening.

In the display device according to aspects of the present disclosure, a first opening and a second opening may be arranged with a space between the first opening and the second opening in a horizontal direction, not in a vertical direction, in a dashboard or a console, and the display screen may be exposed in a right direction or a left direction from each opening. The display device is not limited to a display device for a vehicle, and can be used for household use, theater use, or the like.

### BRIEF DESCRIPTION OF THE DRAWINGS

FIG. 1 is a perspective view illustrating a display device according to a first embodiment of the present disclosure for in-vehicle use and illustrating a use state in which a display screen of a display unit protrudes from each of an upper opening (first opening) and a lower opening (second opening);
FIG. 2 is a perspective view illustrating a use state in which the display unit of the display device illustrated in FIG. 1 is moved to an upper limit position and a dimension of a protrusion of the display screen from the upper opening is increased;
FIG. 3 is a perspective view illustrating a use state in which the display unit of the display device illustrated in FIG. 1 is moved to a lower limit position and the display screen is protruded only from the lower opening;
FIG. 4 is a partial perspective view illustrating an embodiment of a moving mechanism and the display unit provided inside a panel as viewed from a vehicle front side;
FIG. 5 is a partial perspective view illustrating an embodiment of the moving mechanism and the display unit provided inside the panel as viewed from the inside of a vehicle interior;
FIG. 6 is a vertical sectional view illustrating an embodiment of the moving mechanism in the use state illustrated in FIG. 1;
FIG. 7 is a vertical sectional view illustrating an embodiment of the moving mechanism in the use state illustrated in FIG. 2;
FIG. 8 is a vertical sectional view illustrating an embodiment of the moving mechanism in the use state illustrated in FIG. 3;
FIG. 9 is a perspective view illustrating a display device according to a second embodiment of the present disclosure and illustrating a use state in which a display screen of a display unit protrudes only from an upper opening;
FIG. 10 is a perspective view illustrating a display device according to a third embodiment of the present disclosure and illustrating a structure in which an operation portion is disposed between an upper opening (first opening) and a lower opening (second opening);
FIG. 11 is a vertical sectional view illustrating the display device according to the third embodiment illustrated in FIG. 10; and
FIG. 12 is a perspective view illustrating a display device according to a fourth embodiment of the present disclosure and illustrating a structure in which a display portion is disposed between an upper opening (first opening) and a lower opening (second opening).

In the inventions described in Patent Document 1 and Patent Document 2, a liquid crystal monitor (display) is installed such that a dimension of an upward protrusion from an instrument panel or a center console can be varied. However, in order not to obstruct the forward field of vision while driving, the upward protrusion of the liquid crystal monitor is reduced, and most of the display screen area is contained within the instrument panel, and the like. Therefore, the display screen of the display monitor cannot be used effectively, and only limited information can be displayed.

According to an embodiment of the present disclosure, it is desirable to provide a display device capable of displaying various information by effectively utilizing a display screen of a display unit.

In the display device according to aspects of the present disclosure, since the display screen of the display unit protrudes from each of the first opening and the second opening, the display screen can be effectively used, and various displays can be performed by changing dimensions of the protrusions of the display screen from the first opening and the second opening. Further, since the surface of the panel appears between the first opening and the second opening, the design of the vehicle interior can be simplified, and the operation portion and a fixed display portion can be disposed between the first opening and the second opening.

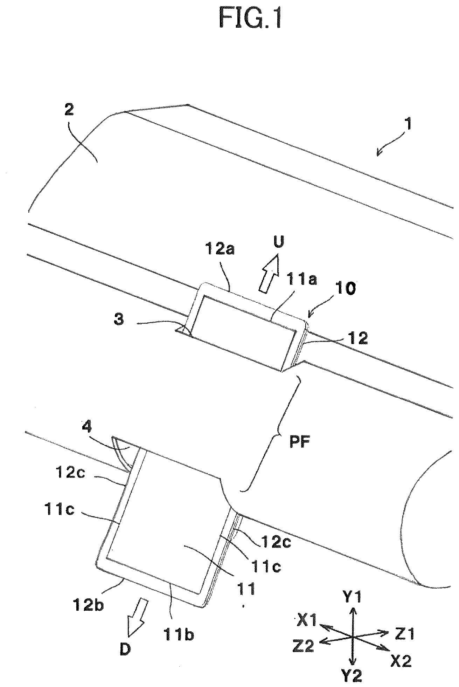

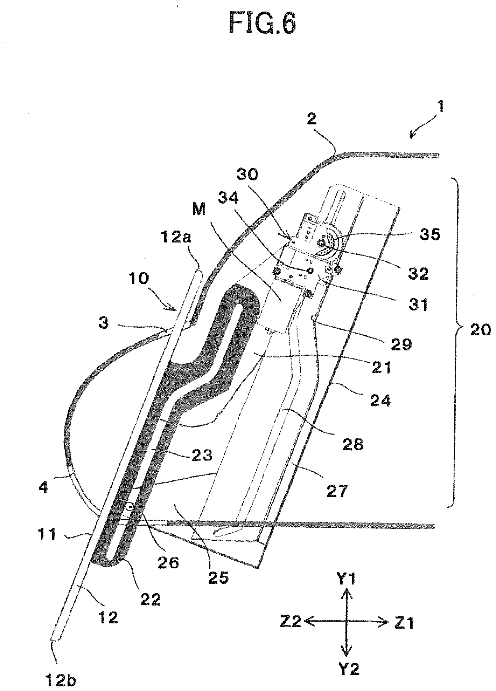

FIGS. 1 to 8 illustrate an in-vehicle display device 1 as a display device according to a first embodiment of the present disclosure. As illustrated in FIGS. 1 to 3, in the in-vehicle display device 1, a Y1 to Y2 direction is a vertical direction, the Y1 direction is an upward direction, and the Y2 direction is a downward direction. A X1 to X2 direction is a horizontal direction, a X1 direction is a leftward direction, and a X2 direction is a rightward direction. As illustrated in FIGS. 6 to 8, a Z1 to Z2 direction with respect to the vehicle body is a front-rear direction. The Z1 direction is a forward direction of the vehicle traveling and is further inward of the panel. The Z2 direction is the rearward direction, a vehicle inward direction, and an outward direction of the panel.

The in-vehicle display device 1 includes a panel 2. The panel 2 forms a part of an instrument panel or a dashboard located in front of a driver's seat and a passenger's seat. The panel 2 may be a part of a center console located between the driver's seat and the passenger's seat. An upper opening 3 as a first opening and a lower opening 4 as a second opening are formed in the panel 2 with a space between the upper opening 3 and the lower opening 4 in the vertical direction (Y1 to Y2 direction).

A display unit 10 is provided in the in-vehicle display device 1. The display unit 10 has a display panel such as a liquid crystal display panel or an electroluminescence display panel having an LED backlight built in a thin case 12. As illustrated in FIGS. 1 to 3, the case 12 of the display unit 10 has a rectangular shape having an upper end 12a, a lower end 12b, and both side ends 12c and 12c. A display screen 11 of the display panel appears on a surface of the display unit 10 facing rearward (toward the inside of the vehicle interior: Z2 direction). The display screen 11 is rectangular and has an upper end 11a, a lower end 11b, and both side ends 11c and 11c. The upper end 11a of the display screen 11 is located close to the upper end 12a of the case 12, the lower end 11b of the display screen 11 is located close to the lower end 12b of the case 12, and both side ends 11c and 11c of the display screen 11 are located close to both side ends 12c and 12c of the case 12.

The display screen 11 is a screen in which a rectangular area surrounded by an upper end 11a, a lower end 11b, and both side ends 11c and 11c is one continuous screen. The display screen 11 can display a unified image with all pixels arranged in the entire screen, or can also display different images for each screen unit by dividing the display screen 11 into a predetermined number of pixel groups and configuring the screen unit with each pixel group. Further, a plurality of display screens that perform display operations independently of each other may be provided on the front face of the display unit 10 facing the rear (Z2 direction), and a band-shaped non-display area may be formed between adjacent display screens. For example, the upper display screen and the lower display screen may be provided separately.

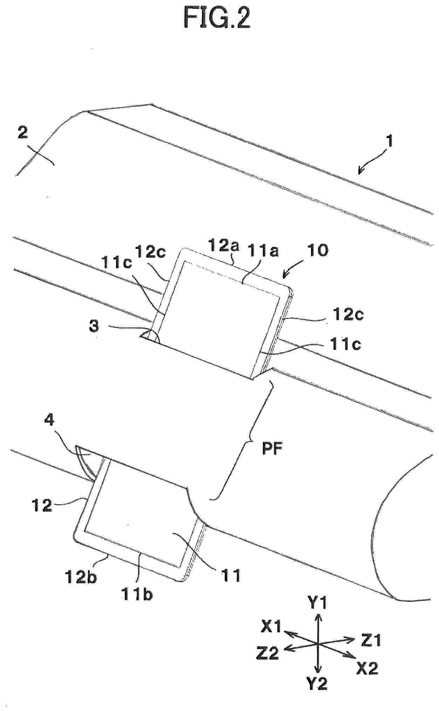

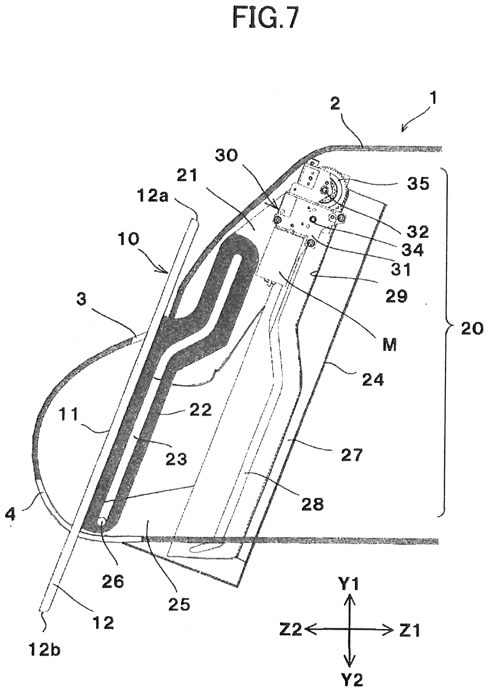

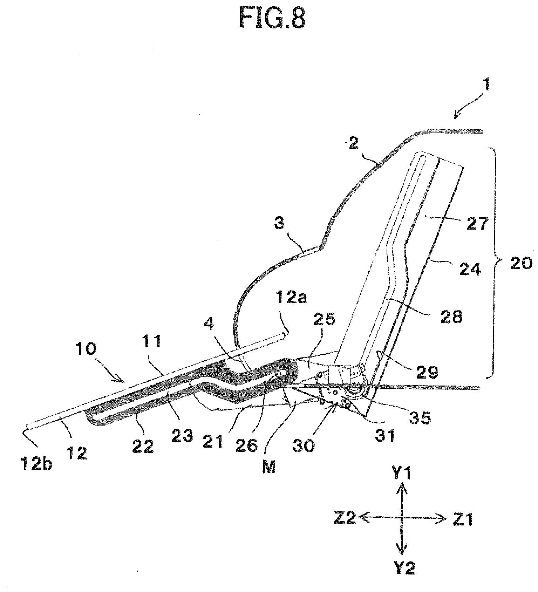

FIGS. 4 to 8 illustrate a moving mechanism 20 provided inside the panel 2. The moving mechanism 20 is driven by a motor M, and the display unit 10 is moved by the moving mechanism 20 between the upper limit position illustrated in FIGS. 2 and 7 and the lower limit position illustrated in FIGS. 3 and 8.

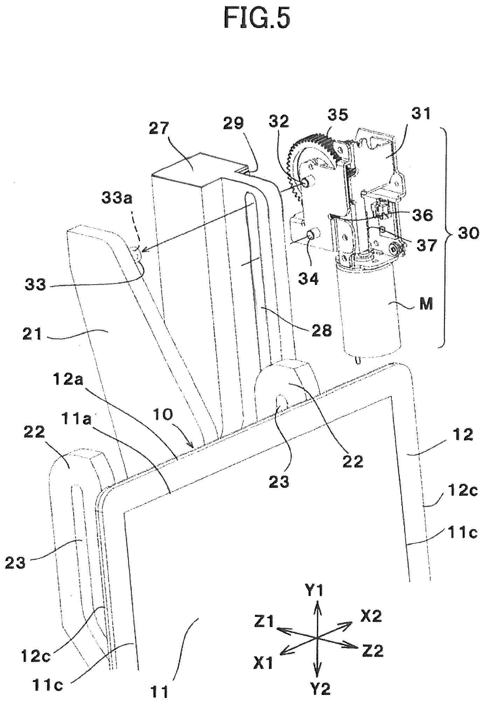

As illustrated in FIGS. 4 and 5, as the movable side constituent members of the moving mechanism 20, the display unit 10 is integrally formed with a pair of movable cam portions 22 protruding forward (in the direction of the Z1) respectively from the left and right side portions of the case 12, and a movable support portion 21 protruding forward from a middle position between the two movable cam portions 22 respectively positioned on the left and right. The movable support portion 21 and the movable cam portions 22 are formed integrally with the case 12 by a synthetic resin material or a light metal material. As illustrated in FIG. 6, each movable cam portion 22 is formed with a movable cam hole 23. The movable cam hole 23 continuously extends from the upper end 12a to the lower end 12b of the case 12 and has a bent portion in the middle.

As illustrated in FIGS. 4 and 6, the moving mechanism 20 is provided with a fixed bracket 24 as a component on the fixed side. The fixed bracket 24 is formed of a metal plate and is fixed to the inside of the panel 2 constituting a part of an instrument panel or the like. A pair of fixed support portions 25 bent rearward (toward the Z2) from both left and right side portions are integrally formed on the fixed bracket 24. A fixed sliding shaft 26 is fixed to a rear end of each of the fixed support portions 25, and each of the fixed sliding shafts 26 is slidably inserted into the movable cam hole 23. A fixed cam portion 27 is fixed to the fixed bracket 24 at a middle position between the left and right fixed support portions 25. As illustrated in FIGS. 5 and 6, the fixed cam portion 27 is formed with a fixed cam hole 28 and a rack portion 29. The fixed cam hole 28 continuously extends in the vertical direction and has a bent portion in the middle. The rack portion 29 is formed by arranging fixed teeth so as to follow the fixed cam hole 28.

The moving mechanism 20 is provided with a drive mechanism 30 including the motor M as a power source. As illustrated in FIG. 5, the drive mechanism 30 is provided with a gear bracket 31, and the motor M is fixed to the gear bracket 31. A main shaft 32 is provided on the gear bracket 31, and the gear bracket 31 is rotatably supported by the main shaft 32. A movable sliding shaft 33 is fixed to the tip of a movable support portion 21 formed integrally with the case 12 of the display unit 10, and the movable sliding shaft 33 is slidably inserted into the fixed cam hole 28. A coupling hole 33a is formed in the movable sliding shaft 33, and the main shaft 32 is inserted into and fixed to the coupling hole 33a. The coupling hole 33a is a female screw, and the main shaft 32 is a male screw, and the main shaft 32 is screwed into and fixed to the coupling hole 33a. Alternatively, the main shaft 32 may be press-fitted into the coupling hole 33a.

As illustrated in FIG. 5, the movable support portion 21 and the drive mechanism 30 are positioned with the fixed cam portion 27 interposed between the movable support portion 21 and the drive mechanism 30, and the movable support portion 21 and the drive mechanism 30 are connected to each other via the movable sliding shaft 33 which penetrates the fixed cam hole 28. The entire drive mechanism 30 is rotatable about the main shaft 32 connected to the movable sliding shaft 33. A sliding auxiliary shaft 34 is fixed to the gear bracket 31, and the sliding auxiliary shaft 34 is inserted into the fixed cam hole 28. The movable sliding shaft 33 to which the main shaft 32 is connected and the sliding auxiliary shaft 34 slide in the fixed cam hole 28, and thus the drive mechanism 30 moves in the vertical direction together with the movable support portion 21 while changing the posture in response to the change in the trajectory of the fixed cam hole 28. In the moving mechanism 20, a cam guide mechanism for guiding the display unit 10 upward and downward with respect to the fixed side is formed by the movable cam hole 23, the fixed sliding shaft 26, the fixed cam hole 28 and the movable sliding shaft 33.

As illustrated in FIG. 5, in the drive mechanism 30, a worm gear 37 is fixed to an output shaft of the motor M fixed to the gear bracket 31, and the worm gear 37 meshes with a small gear 36 rotatably supported by the gear bracket 31. A pinion gear 35 is rotatably supported by the main shaft 32 that rotatably supports the gear bracket 31, and the rotational output power of the worm gear 37 is reduced in angular velocity through the small gear 36 and transferred to the pinion gear 35. As illustrated in FIG. 6, the pinion gear 35 meshes with the rack portion 29 formed on the fixed cam portion 27. The rack portion 29 forms a part of a drive mechanism 30.

Next, the display operation of the in-vehicle display device 1 will be described. In the in-vehicle display device 1, when the motor M of the drive mechanism 30 is started, the rotational power is decelerated and applied to the pinion gear 35. The pinion gear 35 is rotated while meshing with the rack portion 29 formed on the fixed cam portion 27, whereby a moving force is applied to the display unit 10. The movable sliding shaft 33 provided on the movable support portion 21 slides in the fixed cam hole 28 formed in the fixed cam portion 27, and the movable cam holes 23 formed in the pair of movable cam portions 22 allow the fixed sliding shaft 26 provided on the fixed support portion 25 to slide, whereby the display unit 10 is moved between the upper limit position illustrated in FIGS. 2 and 7 and the lower limit position illustrated in FIGS. 3 and 8 while changing its posture. The display unit 10 can be stopped at any position between the upper limit position and the lower limit position.

In the use state illustrated in FIGS. 1 and 6, the display unit 10 is stopped at a neutral position where the display unit 10 is moved slightly downward from the upper limit. In the use state of the neutral position, a part of the display screen 11 provided in the display unit 10 protrudes upward from the upper opening (first opening) 3, and a part of the display screen 11 protrudes downward from the lower opening (second opening) 4. The display area of the display screen 11 exposed from the lower opening 4 is slightly larger than the display area of the display screen 11 exposed from the upper opening 3. In the use state of the neutral position, for example, a relatively small amount of information such as a right-turn or left-turn guide arrow display, a traveling speed display, or a warning display is displayed in an area exposed from the upper opening 3 in the display screen 11. For example, the display area of the display screen 11 exposed from the lower opening 4 is used for displays that the driver does not need to frequently see, such as an operation portion display of an acoustic device, an operation portion display of an air conditioner, and an operation state display of the air conditioner.

The display area of the display screen 11 exposed from the upper opening 3 and the display area of the display screen 11 exposed from the lower opening 4 can be changed to any given size by operating the motor M of the drive mechanism 30 to move the display unit 10 upward (U direction) or downward (D direction) to any given position and stop the display unit 10 from the use state of the neutral position illustrated in FIGS. 1 and 6. With the change in the display area, the display on the display screen 11 is switched to information different from the use state illustrated in FIGS. 1 and 6.

When the display unit 10 is moved upward (in the U direction) to the upper limit position from the use state of the neutral position illustrated in FIGS. 1 and 6 and is stopped, the display unit 10 is set to the use state of the upper limit position illustrated in FIGS. 2 and 7. In the use state of the upper limit position, the display area of the display screen 11 exposed from the upper opening 3 is increased as compared with the neutral use state illustrated in FIGS. 1 and 6, while the display area of the display screen 11 exposed from the lower opening 4 is decreased as compared with the neutral use state. In the use state of the upper limit position, a guidance map screen or traveling information of an automobile when a car navigation system is operating, for example, operation information of an automatic driving system or charging information of an electric automobile is displayed in a display area exposed from the upper opening 3 of the display screen 11. The display area of the display screen 11 exposed from the lower opening 4 is used for displays that the driver does not need to frequently see, such as an operation portion display of an acoustic device, an operation portion display of an air conditioner, and an operation state display of the air conditioner.

When the display unit 10 is moved downward (in the direction D) from the use state of the neutral position illustrated in FIGS. 1 and 6 to the lower limit position and is stopped, the display unit 10 is set to the use state of the lower limit position illustrated in FIGS. 3 and 8. In the use state of the lower limit position, a part or an entirety of the display screen 11 is exposed only from the lower opening 4, and the display screen 11 is not exposed from the upper opening 3. When the display unit 10 is stopped at the neutral position illustrated in FIG. 6 and at the upper limit position illustrated in FIG. 7, a rising angle θ1 from the horizontal plane of the display screen 11 is the same in both cases. When the display unit 10 is stopped at the lower limit position as illustrated in FIG. 8, a rising angle θ2 of the display screen 11 from the horizontal plane becomes smaller than the angle 91, and the display screen 11 is turned upward in a posture close to the horizontal posture as illustrated in FIG. 3. In the use state of the lower limit position, for example, information suitable for use at the time of being stopped is displayed. For example, the displays include a keyboard display for inputting information, an information display and an operation portion display for accessing a computer mounted on the vehicle to perform self-diagnosis, a television display, a recording display, and the like.

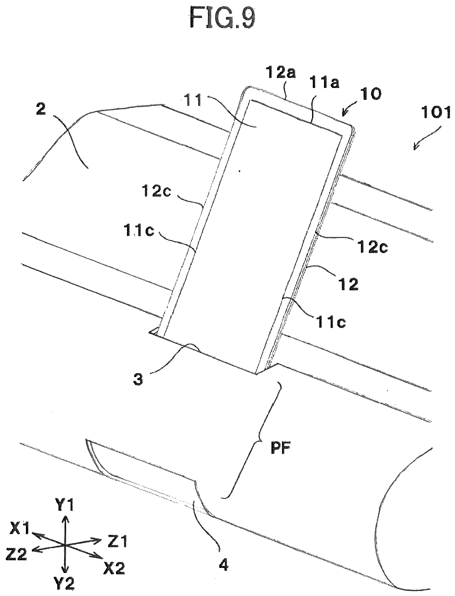

In an in-vehicle display device 101 according to a second embodiment illustrated in FIG. 9, the cam guide mechanism of the moving mechanism 20 extends further upward relative to the cam guide mechanism of the first embodiment, and the display unit 10 can move further upward relative to the upper limit position of the first embodiment illustrated in FIGS. 2 and 7. At the upper limit position of the display unit 10 illustrated in FIG. 9, a part or an entirety of the display screen 11 protrudes only from the upper opening 3, and the display screen is not exposed from the lower opening 4. Almost all the areas of the display screen 11 protruding upward from the upper opening 3 can be used as a display area, and for example, a television image can be displayed while the vehicle is stopped, or a recorded image can be displayed. Further, when the upper opening 3 is located at a relatively low position and the display screen 11 protruding upward is unlikely to obstruct the driving field of view, a guide map of the navigation device can be displayed as a large screen on the display screen 11.

In the in-vehicle display device 1 or 101 according to the embodiment, the display unit 10 can be stopped at a position where a part of the display screen 11 protrudes from each of the upper opening 3 and the lower opening 4, and in this state, the exposed area of the display screen 11 from the upper opening 3 and the exposed area of the display screen 11 from the lower opening 4 can be changed. Since the display image in the upper part and the display image in the lower part can be realized by one display unit 10, various displays can be implemented by one display unit 10 and one video processing circuitry.

In the in-vehicle display device 1 or 101 according to the embodiment, the display unit 10 moved by the moving mechanism 20 can be stopped at a position where at least a part of the display screen 11 protrudes from the upper opening (first opening) 3 and at a position where at least a part of the display screen 11 protrudes from the lower opening (second opening). Further, the display screen 11 can be stopped at a position where the display screen 11 is exposed only from the upper opening 3 and at a position where the display screen 11 is exposed only from the lower opening 4. Since the display screen 11 of one display unit 10 can be set to a state exposed from the upper opening 3 and a state exposed from the lower opening 4, various displays corresponding to applications can be performed at the upper and lower parts without arranging separate display units at the upper and lower parts.

As illustrated in FIGS. 1 and 9, in the in-vehicle display device 1 or 101 according to the embodiment, no member is disposed in a middle area PF between the upper opening 3 and the lower opening 4 in the panel 2, and the surfaces of the instrument panel or dashboard, and the like, in the middle area PF and the areas to the left and right of the middle area PF have a continuous appearance from left to right. Since the panel 2 has the appearance of being continuous from left to right even though the display screen 11 appears from the upper part and the lower part, the front part in the vehicle interior can be simply decorated with a high quality of design.

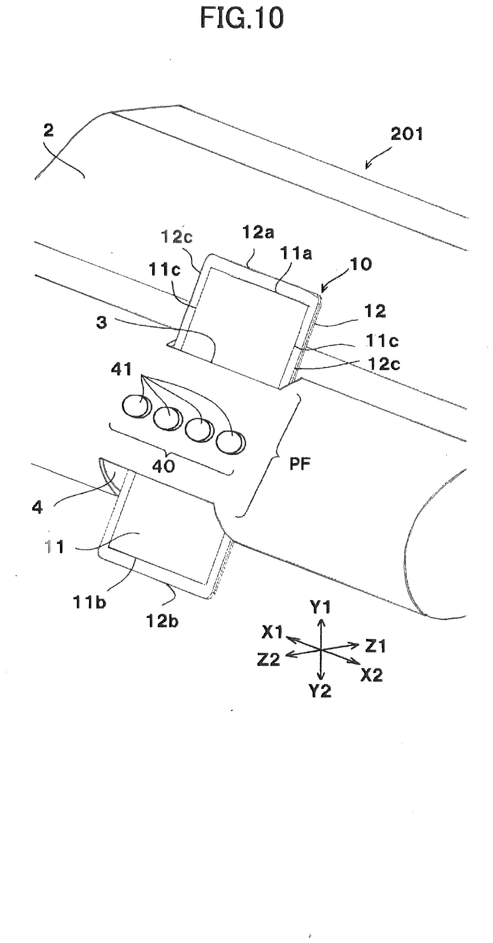

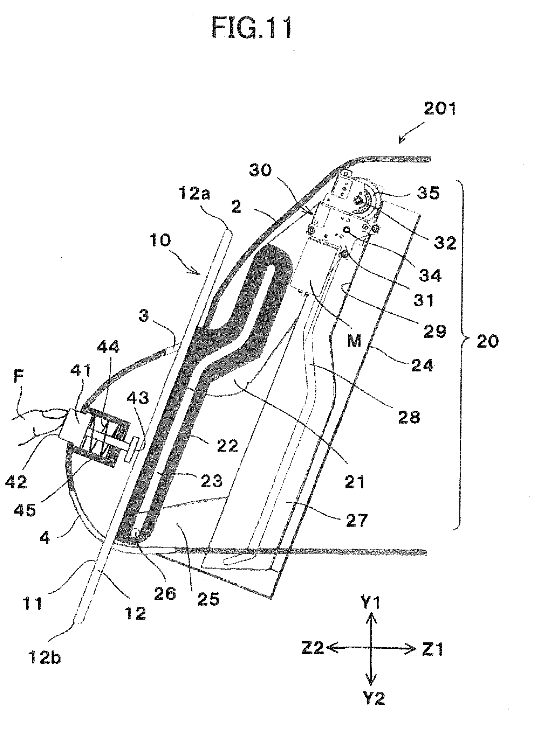

However, as in the in-vehicle display device 201 according to the third embodiment and the in-vehicle display device 301 according to the fourth embodiment, the operation portion and a display portion may be provided in the middle area PF of the panel 2. In the in-vehicle display device 201 according to the third embodiment illustrated in FIG. 10, the operation portion 40 is provided in the middle area PF between the upper opening 3 and the lower opening 4 of the panel 2. The operation portion 40 is provided with a plurality of operation buttons 41. FIG. 11 is a sectional view of the operation portion 40. Each operation button 41 has an operation contact portion 42 with which a finger F of a person comes into contact and an operation facing portion 43 facing the display screen 11. The operation contact portion 42 and the operation facing portion 43 are conductive, and the operation button 41 is provided with a conductive path for conducting the operation contact portion 42 and the operation facing portion 43. A holder portion 45 is formed inside the middle area PF of the panel 2, and the operation button 41 is held by the holder portion 45 so as to be freely advanced and retreated. A spring member 44 for preloading the operation button 41 in a direction in which the operation button 41 protrudes from the surface of the panel 2 is provided inside the holder portion 45.

In the display screen 11 of the display unit 10, a capacitance-type sensor is provided on the inner surface plate of the display panel. The capacitance-type sensor is provided with a plurality of transparent electrodes on the inner surface plate, and when a finger F of a person approaches or touches the sensor, the capacitance-type sensor detects a change in mutual capacitance or a change in self-capacitance, and specifies a coordinate position where the finger F approaches or touches the sensor. As illustrated in FIG. 11, when the finger F touches the operation contact portion 42 of the operation button 41 while the display unit 10 is moving up and down and is stopped at any position, the operation facing portion 43 has substantially the same ground potential as the finger F. The capacitance-type sensor provided on the display screen 11 detects a change in capacitance, and thus it is possible to recognize which operation button 41 is touched by the finger F. When the operation button 41 is further pressed by the finger F touching the operation contact portion 42, the operation facing portion 43 comes into contact with the surface of the display screen 11, and the mutual capacitance or the self-capacitance of the sensor further changes. By detecting this capacitance change, it is possible to recognize that the operation is an input operation, for example. Note that the operation input may not be determined when the finger F touches the operation contact portion 42. The operation input may be determined only when the operation button 41 is pressed by the finger F touching the operation contact portion 42 so that the operation facing portion 43 touches the surface of the display screen 11.

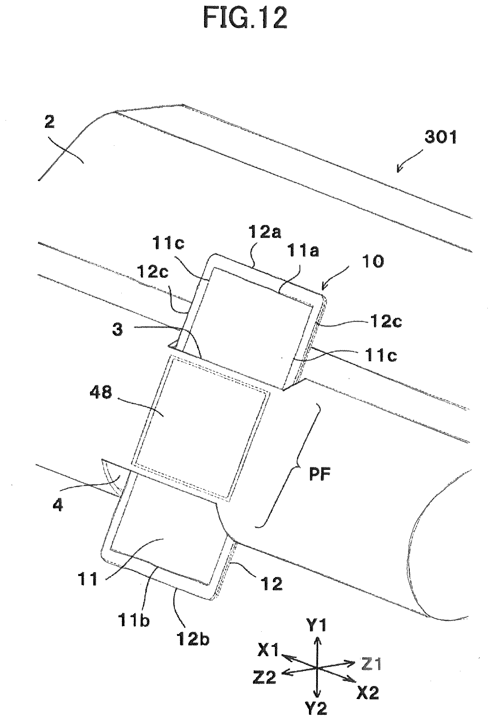

In an in-vehicle display device 301 according to the fourth embodiment illustrated in FIG. 12, a display portion 48 is fixed to the middle area PF of the panel 2. The display portion 48 is a liquid crystal display panel or an electroluminescence display panel. In the in-vehicle display device 301, even though a dimension of a protrusion of the display unit 10 from the upper opening 3 is reduced to secure a wide driving field of view in front, the image can be displayed in a wide area by using a partial area of the display screen 11 exposed from the upper opening 3, a partial area of the display screen 11 exposed from the lower opening 4, and the fixed display portion 48.

The display device according to the present disclosure may have a structure in which a first opening and a second opening open in a panel such as an instrument panel or a center console with a space between the first opening and the second opening in a horizontal direction, and a display screen of a display unit protrudes from the respective openings in the left direction and in the right direction. The display device is not limited to the in-vehicle display device, and may be a display device for household use or theater use.

Although the present invention has been described with reference to the embodiment, the present invention is not limited to the configurations and elements described in the embodiment, and the configurations and the elements described in the embodiment may be combined with other configurations and elements, and the above-described embodiment can be changed as appropriate without departing from the scope of the claimed subject matter.

## Claims

1. A display device comprising:
a display unit movably attached to an inside of a panel;
a first opening and a second opening formed in the panel with a distance between the first opening and the second opening; and
a moving mechanism provided inside the panel, the moving mechanism being configured to move the display unit using power,
wherein the display unit moved by the moving mechanism is configured to be stopped at a position where a part of a display screen protrudes from each of the first opening and the second opening.

2. The display device according to claim 1,
wherein the display unit is configured to be moved by the moving mechanism to change a dimension of a protrusion of the display screen from the first opening and a dimension of a protrusion of the display screen from the second opening.

3. A display device comprising:
a display unit movably attached to an inside of a panel;
a first opening and a second opening formed in the panel with a distance between the first opening and the second opening; and
a moving mechanism provided inside the panel, the moving mechanism being configured to move the display unit using power,
wherein the display unit moved by the moving mechanism is configured to be stopped at a position where at least a part of the display screen protrudes from the first opening and at a position where at least a part of the display screen protrudes from the second opening.

4. The display device according to claim 3,
wherein the display unit moved by the moving mechanism is configured to be stopped at a position where a part of or an entirety of the display screen protrudes only from the first opening.

5. The display device according to claim 4,
wherein the display unit is configured to be moved by the moving mechanism to change a dimension of a protrusion of the display screen from the first opening.

6. The display device according to claim 3,
wherein the display unit moved by the moving mechanism is configured to be stopped at a position where a part of or an entirety of the display screen protrudes only from the second opening.

7. The display device according to claim 6,
wherein the display unit is configured to be moved by the moving mechanism to change a dimension of a protrusion of the display screen from the second opening.

8. The display device according to one of claims 1 to 7,
wherein the panel is a part of a dashboard, an instrument panel, or a console provided in a vehicle interior, and
wherein the first opening opens upward, and the second opening opens downward.

9. The display device according to claim 8, wherein an operation portion is provided on a surface of the dashboard, the instrument panel, or the console between the first opening and the second opening.

10. The display device according to claim 8 or 9, wherein a display portion is provided on a surface of the dashboard, the instrument panel, or the console between the first opening and the second opening.
